Europäisches Patentamt

European Patent Office

Office européen des brevets

(19)

(11) Veröffentlichungsnummer: **0 333 090**
**A2**

## EUROPÄISCHE PATENTANMELDUNG

(12)

(21) Anmeldenummer: 89104385.3

(22) Anmeldetag: 13.03.89

(51) Int. Cl.4: **H01S 3/23 , H01S 3/19 , H01S 3/07**

(30) Priorität: 17.03.88 DE 3808875

(43) Veröffentlichungstag der Anmeldung:
20.09.89 Patentblatt 89/38

(84) Benannte Vertragsstaaten:
AT BE CH DE ES FR GB IT LI NL SE

(71) Anmelder: **Standard Elektrik Lorenz
Aktiengesellschaft
Lorenzstrasse 10
D-7000 Stuttgart 40(DE)**

(84) **DE**

Anmelder: **ALCATEL N.V.
Strawinskylaan 341 (World Trade Center)
NL-1077 XX Amsterdam(NL)**

(84) **BE CH ES FR GB IT LI NL SE AT**

(72) Erfinder: **Mozer, Albrecht, Dr.
Freiberger Strasse 30
D-7120 Bietigheim-Bissingen(DE)**

(74) Vertreter: **Pohl, Heribert, Dipl.-Ing et al
Standard Elektrik Lorenz AG Patent- und
Lizenzwesen Postfach 30 09 29
D-7000 Stuttgart 30(DE)**

(54) **Halbleiteranordnung zur Erzeugung einer periodischen Brechungsindexverteilung und/oder periodischen Verstärkungsverteilung.**

(57) Zur Reduktion der von einem Halbleiter-Laser erzeugten longitudinalen Moden kann ein in den Laser integriertes homogenes optisches Gitter benutzt werden. Prinzipiell emittieren derartige Laser, die ein optisches Gitter zur Modenreduktion enthalten, zwei longitudinale Moden. Die aus den Schichten 10 und 11 bestehende periodische Halbleiter-Struktur, die durch Hintereinanderschaltung mindestens zweier Halbleiter-Materialien mit den Bandabständen E1 und E2, und den Brechungsindizes n1 und n2 aufgebaut ist (E1 < E2, n1 > n2), kann betrieben werden als:
- passives Interferenzfilter,
- aktives, teilverstärkendes Interferenzfilter,
- optischer schmalbandiger Verstärker
- single-mode-Laser, der nur eine einzige Mode emittiert.

FIG.1A

FIG 1B

# Halbleiteranordnung zur Erzeugung einer periodischen Brechungsindexverteilung und/oder periodischen Verstärkungsverteilung

Die Erfindung betrifft optische Halbleiter-Sender oder Halbleiter-Verstärker mit periodisoher Struktur.

Die Übertragung von Nachrichten über Lichtleitfasern ermöglicht sehr große Datenraten. Für die Nachrichtenübertragung über lange Strecken sind wegen des Dispersionsverhaltens von Lichtleitfasern Laser erforderlich, die eine einzige longitudinale Mode emittieren. Aus der EP-A-0 149 462 ist bekannt, daß sich durch Integration eines optischen Gitters in einen Halbleiter-Laser, im folgenden kurz HL-Laser genannt, die Zahl der vom Laser emittierten Moden reduzieren läßt. Solche Laser heißen DFB-(Distributed Feedback) Laser. Es läßt sich zeigen, daß auch ein DFB-Laser auf zwei longitudinalen Moden emittiert, was hinsichtlich der Energieumwandlung von elektrischer in Strahlungsenergie nicht optimal ist.

Weiterhin ist aus der EP-A-0 213 965 bekannt, einen HL-Laser mit einem abstimmbaren Resonator zu verbinden, um auf diese Weise eine Reduktion der Zahl der longitudinalen Moden zu erreichen. Der in dieser Schrift angegebene Resonator enthält ebenfalls ein optisches Gitter, so daß auch bei dieser Lösung prinzipiell zwei longitudinale Moden abgestrahlt werden.

Aufgabe der Erfindung ist es, einen optischen HL-Sender oder HL-Verstärker so aufzubauen, daß er nur eine einzige Mode verstärkt und so die Emission einer einzigen Mode ermöglicht. Gelöst wird diese Aufgabe durch eine Vorrichtung mit der Merkmalskombination des Hauptanspruches. In den Unteransprüchen sind Weiterbildungen und Ausgestaltungen des HL-Senders oder HL-Verstärkers angegeben.

Die erfindungsgemäße Anordnung hat den Vorteil, daß sie universell für verschiedenste Bereiche in der optischen Nachrichtenübertragung eingesetzt werden kann. Diese Anordnung kann verwendet wrden als:

1. passives Interferenzfilter,
2. aktives, in seiner Bandbreite durchstimmbares Interferenzfilter,
3. aktiver, longitudinal einmodiger Sendelaser.

Im folgenden werden mehrere Ausführungsbeispiele der Erfindung beschrieben und anhand der Figuren 1 bis 5 näher erläutert. Es zeigen:

Fig. 1a den prinzipiellen Aufbau des HL-Verstärkers oder HL-Lasers,

Fig. 1b den Verlauf der Brechungsindizes und des Bandabstandes in einer derartigen Anordnung,

Fig. 2a ein erstes Ausführungsbeispiel,

Fig. 2b ein zweites Ausführungsbeispiel,

Fig. 2c ein drittes Ausführungsbeispiel,

Fig. 3 das Prinzip des passiven oder aktiven Interferenzfilters,

Fig. 4 das Verhältnis von eingestrahlter Intensität zu reflektierter Intensität bei einem Interferenzfilter,

Fig. 5 die Verstärkung einer einzigen longitudinalen Mode in einer derartigen Strukturfolge.

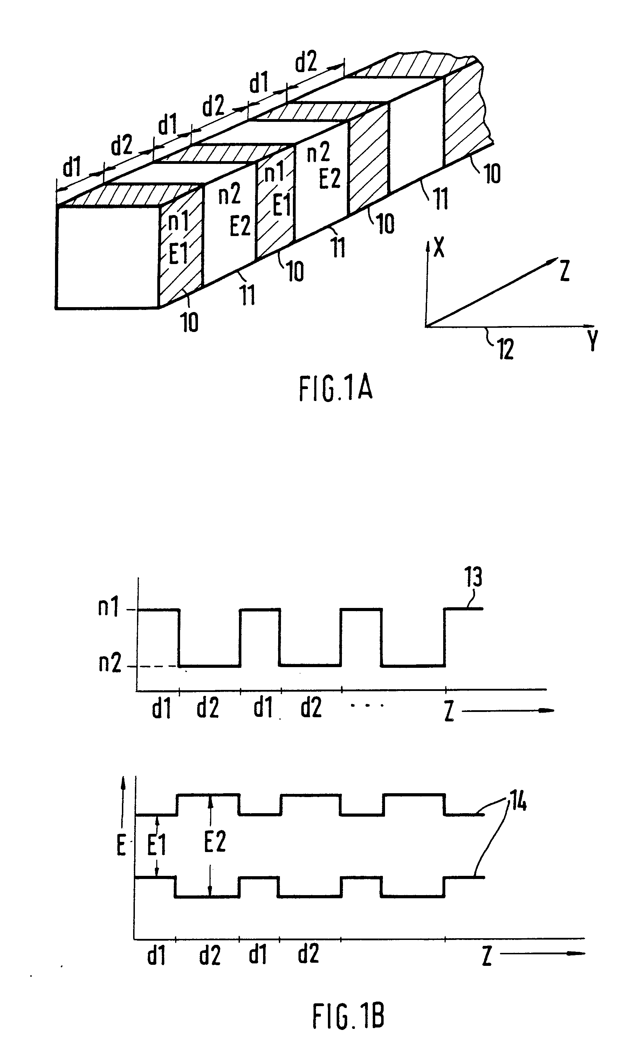

Fig. 1a zeigt den prinzipiellen Aufbau des optischen HL-Lasers oder HL-Verstärkers. Mit 10 ist eine Schicht bezeichnet, die aus einem ersten HL-Material besteht, welches den Brechungsindex $n1$ und den Banbdabstand $E1$ hat. 11 bezeichnet eine zweite Schicht, die den Brechungsindex $n2$ und den Bandabstand $E2$ hat. Die aus den beiden Schichten 10 und 11 bestehende Schichtenfolge wiederholt sich, wie Fig. 1a zu entnehmen ist, mehrere Male. Die Dicken der einzelnen Schichten sind mit $d1$ und $d2$ bezeichnet. Sie sind, je nach Anwendungsfall, unterschiedlich. Mit 12 ist ein Koordinatensystem gekennzeichnet, das die räumliche Lage der Halbleiteranordnung kennzeichnen soll. Die Ausbreitungsrichtung des vom Verstärker verarbeiteten Lichtes oder die Ausbreitungsrichtung des Lichtes bei Laserbetrieb ist die z-Richtung. Im oberen Diagramm von Fig. 1b ist mit 13 der Verlauf des Brechungsindex in z-Richtung der Halbleiteranordnung nach Fig. 1a dargestellt. Im Diagramm darunter ist mit 14 der Verlauf des Bandabstandes in z-Richtung aufgetragen. In dem gewählten Beispiel hat das Material mit dem kleineren Bandabstand $E1$ den größeren Brechungsindex $n1$. Auch der umgekehrte Fall kann realisiert werden.

Grundsätzlich ist auch eine Schichtenfolge denkbar, die aus mehr als zwei verschiedenen Halbleitermaterialien besteht. In Fig. 1 wären dann Materialien mit Brechungsindizes $n1$ bis $nj$ und Bandabstände $E1$ bis $Ej$ vorzusehen. Die im folgenden beschriebenen Ausführungsbeispiele bestehen nur aus zwei verschiedenen Halbleitermaterialien. Eine Struktur nach Abbildung 1a kann z.B. mit Hilfe der Materialien $Ga_xIn_{1-x}As_yP_{1-y}$ und $InP$ erzeugt werden. Beim erstgenannten Material kann je nach Zusammensetzung der Bandabstand variiert werden, es wird hier ein Bandabstand $E1$ von 1,0 eV gewählt bei einem Brechungsindex $n1$ von 3,4. Das zweite gewählte Material $InP$ hat einen Bandabstand $E2$ von 1,35 eV und einen Brechungsindex $n2$ von 3,2. Prinzipiell können auch andere Materialsysteme ohne Verlust des Funktionsprinzips benutzt werden.

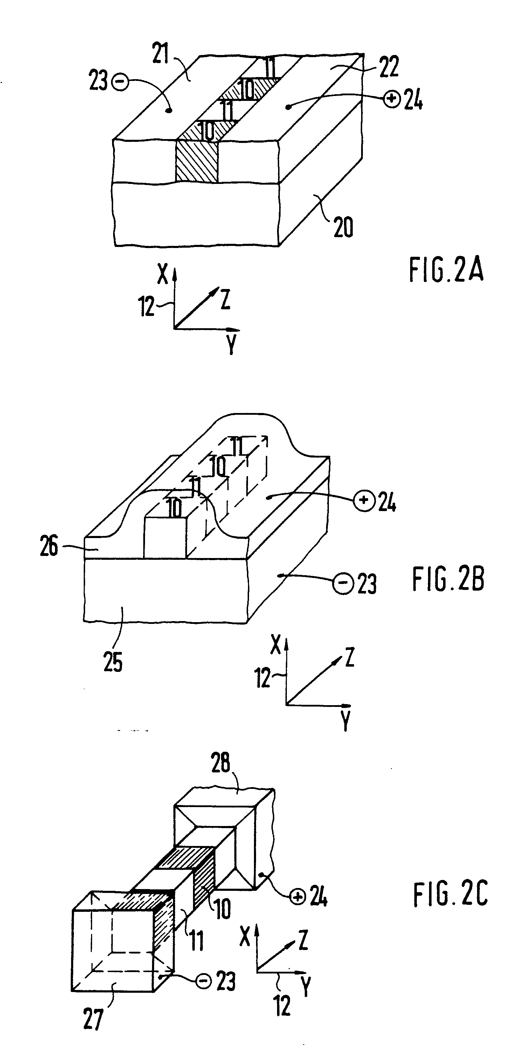

In Fig. 1 war bisher ausschließlich der prinzipielle Aufbau der Schichtenfolge wiedergegeben. Fig. 2 zeigt drei Ausführungsbeispiele, die die Einbettung der Schichtenfolge nach Fig. 1 in ein HL-Bauelement betreffen. In Fig. 2a ist mit 20 ein semiisolierendes Substrat gekennzeichnet, mit 21 ein n-Halbleiter, im gewählten Beispiel vorteilhafterweise n-InP und mit 22 ein p-Halbleiter (vorteilhafterweise p-InP). 23 und 24 kennzeichnen Kontakte, die die beiden Halbleiter 21 und 22 mit Strom versorgen. Zwischen die Halbleiter 21 und 22 ist der Laser oder der optische Verstärker nach Fig. 1a eingebettet. Die Schichtenfolge ist wie bereits in Fig. 1a mit 10 und 11 gekennzeichnet. Das mit 12 bezeichnete Koordinatensystem gibt auch in diesem Fall die räumliche Lage der Halbleiteranordnung wieder. Fig. 2b zeigt ein weiteres Ausführungsbeispiel, in dem sich der Laser oder optische Verstärker auf einem mit 25 bezeichneten n-Halbleiter (z.B. n-InP) befindet. Die so entstandene Anordnung ist in einen p-Halbleiter (z.B. p-InP) eingebettet. 23 und 24 bezeichnen wie in Fig. 2a die Stromzufuhr. Die räumliche Lage der Anordnung wird durch das Koordinatensystem 12 wiedergegeben. Fig. 2c zeigt ein drittes Ausführungsbeispiel des HL-Lasers oder HL-Verstärkers. Die aus den beiden Schichten 10 und 11 bestehende Schichtenfolge ist hier mit ihren Stirnseiten in einen n-Halbleiter 27 (z.B. n-InP) und einen p-Halbleiter 28 (z.B. p-InP) eingebettet. Zur Stromversorgung dienen die Kontakte 23 und 24. Die räumliche Lage wird, wie bereits in den Figuren 2a und 2b durch das Koordinatensystem 12 wiedergegeben.

Wird an die gezeigten Strukturen gemäß der angezeigten Polarität eine äußere Spannung angelegt, so sammeln sich die injizierten Ladungsträger in dem Halbleitergebiet mit dem kleineren Bandabstand, hier mit $E_1$ bezeichnet. Auf diese Weise wird entlang der z-Achse sowohl eine räumlich periodische Verstärkungsverteilung als auch eine periodische Brechungsindexverteilung realisiert. Diese verschiedenen Periodizitäten lassen sich vorteilhaft für verschiedenartige Bauelementetypen verwenden; es sind dies z.B.

1. passive Interferenzfilter,
2. aktive, schmalbandig verstärkende Interferenzfilter,
3. optische, schmalbandige Repeater,
4. einmodige Sendelaser.

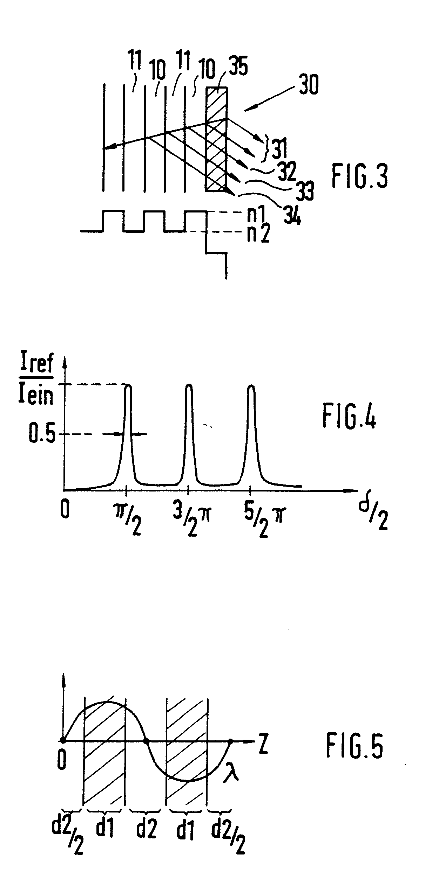

Die physikalische Wirkungsweise dieser Halbleiterstruktur als passives Interferenzfilger zeigen Fig. 3 und Fig. 4 und die relevanten mathematischen Gleichungen sind im Anhang zusammengefaßt.

Die physikalische Wirkungsweise dieser Halbleiterstruktur als aktives Interferenzfilter oder schmalbandiger Verstärker sei im folgenden kurz erläutert. Wird die Halbleiterstruktur gepumpt (Strominjektion) und liegt die Energie des einfallenden Lichtstrahles zwischen der der beiden Bandabstände $E_1$ und $E_2$, so wird das ankommende Licht in den Bereichen von $E_1$ noch verstärkt. Die prinzipielle Funktionsweise ist ähnlich wie im Fall der ungepumpten Struktur bzw. des passiven Interferenzfilters.

Mit Hilfe von Fig. 5 ergibt sich eine weitere Verwendungsart der gezeigten Halbleiteranordnung, und zwar zur Erzeugung einer Single-Mode-Emission. Dabei wird im wesentlichen die räumlich periodische Verstärkungsverteilung genutzt. Durch die periodische Struktur und die periodische Verteilung der Verstärkung wird der Strahlung im Halbleiter eine Verteilung aufgezwungen, welche zu einer Single-Mode-Emission führt. Zu diesem Zweck wird die Halbleiterstruktur über die Laserschwelle gepumpt, wobei sich stehende Wellen im Halbleiter ausbilden. Diese werden in den Schwingungsbäuchen verstärkt, nicht aber in den Schwingungsknoten. Über die Gesamtlänge bildet sich auf diese Weise nur eine einzige Schwingungsmode aus, welche dann zur Single-Mode-Emission führt. Die Struktur stellt somit einen Monomodelaser dar, der nur auf einer einzigen Mode schwingt, und nicht, wie die bisher verwendeten DFB-Laser, prinzipiell auf zwei Moden. Dadurch entfällt die Problematik eines $\frac{\lambda}{4}$-Phasenanpassungsgebietes, welches bei den herkömmlichen DFB-Lasern vorzusehen ist, um Einmodenbetrieb zu realisieren.

Anhang

Von rechts falle ein mit 30 gekennzeichneter Lichtstrahl auf die Anordnung nach Fig. 3. Die Energie der Photonen des Lichtstrahles 30 sei kleiner als der Bandabstand $E_1$ (nur beim passiven Interferenzfilter). Mit 35 ist eine Lambda/4 Entspiegelungsschicht gekennzeichnet. Auf diese Entspiegelungsschicht folgen die bereits bekannten Schichten 10 und 11 mehrmals hintereinander. Die an der Lambda/4-Schicht reflektierten Strahlen 31 heben sich durch Interferenz auf. Das reflektierte Licht setzt sich aus den mit 32, 33, 34 ... bezeichneten Strahlen zusammen. Aus Gründen der Übersichtlichkeit wurde auf die Darstellung weiterer reflektierter Strahlen verzichtet. Für die an der periodischen Struktur reflektierte Lichtwelle $\psi_{ref}$ gilt:

$$\mathcal{Y}_{ref} = \sum_{i=1}^{\infty} \psi_i$$

Für die reflektierte Intensität gilt in erster Näherung:

$$I_{ref} \sim \frac{I_{ein}}{(2-r)^2 - 4(1-r)\ sin^2 (\delta/2)} \qquad (1)$$

In Gleichung (1) ist r der Reflektionskoeffizient des elektrischen Feldes mit

$$r = \left| \frac{n1 - n2}{n1 + n2} \right| \quad ,$$

$\delta$ ist die Phasenverschiebung zwischen benachbarten Teilwellen. Gleichung (1) erreicht Maxima für folgende Werte von $\delta/2$:

$$\delta/2 = \frac{\pi}{2}, \ \frac{3\pi}{2}, \ \frac{5\pi}{2} \ldots$$

Damit errechnen sich die Schichtdicken d1 und d2 zu

$$d1 = \frac{\lambda}{n1} \ (\frac{1}{4}, \ \frac{3}{4}, \ \frac{5}{4} \ldots) \qquad und$$

$$d2 = \frac{\lambda}{n2} \ (\frac{1}{4}, \ \frac{3}{4}, \ \frac{5}{4} \ldots)$$

Für diese Werte von d1 und d2 tritt konstruktive Interferenz auf. $\lambda$ ist dabei die Emissionswellenlänge des einfallenden Lichtstrahles 30.

In Fig. 4 ist der Verlauf der reflektierten Intensität aus Gleichung (1) in Abhängigkeit von der Phasenverschiebung $\delta$ aufgetragen.

Damit ist man nun in der Lage, ein Interferenzfilter aus Halbleitern herzustellen, dessen Schwerpunktwellenlänge (maximale Reflexion des Filters) durch die Dicken d1 und d2 beliebig eingestellt werden kann, und dessen Halbwertsbreite durch Wahl des Reflexionsamplitudenkoeffizienten r, bzw. durch Wahl der Brechungsindizes n1 und n2 ebenfalls in weiten Grenzen beliebig eingestellt werden kann. Die bisher angestellten Betrachtungen gelten allgemein für jede beliebige Emissionswellenlänge $\lambda$ des einfallenden Lichtstrahles und für die ungepumpte Halbleiterstruktur.

## Ansprüche

1. Vorrichtung zur Verstärkung von Licht,
**gekennzeichnet durch** eine periodische Folge verschiedener Halbleiterschichten.

2. Vorrichtung nach Anspruch 1, dadurch gekennzeichnet, daß die Dicke der Halbleiterschichten je nach Anwendungsfall verschieden ist.

3. Vorrichtung nach den Ansprüchen 1 und 2, gekennzeichnet durch eine periodische Folge von zwei oder mehreren verschiedenen Halbleiterschichten.

4. Vorrichtung nach Anspruch 3, dadurch gekennzeichnet, daß die Bandabstände der Materialien aufeinanderfolgender Schichten unterschiedlich sind.

5. Vorrichtung nach Anspruch 4, dadurch gekennzeichnet, daß die Brechungsindizes der Materialien aufeinanderfolgender Schichten verschieden sind.

6. Vorrichtung nach einem oder mehreren der Ansprüche 1 bis 5, dadurch gekennzeichnet, daß die Schichten aus ternären oder quaternären Mischkristallen bestehen.

7. Vorrichtung nach den Ansprüchen 1 bis 6, dadurch gekennzeichnet, daß die Schichten, die aus dem Material mit dem kleineren Bandabstand bestehen, elektrisch gepumpt werden.

8. Vorrichtung nach Anspruch 7, dadurch gekennzeichnet, daß die periodische Folge von Halbleiter-Schichten auf einem semiisolierenden Substrat aufgebracht und an ihren Längsseiten von einem p- bzw. n-Halbleiter-Material umgeben ist.

9. Vorrichtung nach Anspruch 7, dadurch gekennzeichnet, daß die periodische Folge von Halbleiterschichten auf einem n-Halbleitermaterial aufgebracht und in eine Schicht von p-Halbleitermaterial eingebettet ist.

10. Vorrichtung nach Anspruch 7, dadurch gekennzeichnet, daß die periodische Folge von Halbleiterschichten an der einen Stirnseite von einem n-Halbleiter und an der anderen Stirnseite von einem p-Halbleiter begrenzt wird.

11. Vorrichtung nach einem oder mehreren der Ansprüche 1 bis 10, dadurch gekennzeichnet, daß sie zur Verstärkung von Licht mit einer zwischen den beiden Bandabständen der verschiedenen Halbleitermaterialien liegenden Photonen-Energie benutzt wird.

12. Vorrichtung nach Anspruch 11, gekennzeichnet durch ihre Verwendung als
a) passives Interferenzfilter oder
b) aktives, teilverstärkendes Interferenzfilter.

13. Vorrichtung nach Anspruch 11, gekennzeichnet durch ihre Verwendung als schmalbandiger optischer Verstärker.

14. Vorrichtung nach Anspruch 11, gekennzeichnet durch ihre Verwendung zur Erzeugung von Licht mit einer einzigen Schwingungsmode.

15. Vorrichtung nach den Ansprüchen 11 bis 14, gekennzeichnet durch ihre Verwendung als Repeater in optischen Übertragungsstrecken.

FIG.1A

FIG.1B

A.Mozer 10
15. 3. 88

FIG.2A

FIG.2B

FIG.2C

A.Mozer 10
15. 3.88

FIG.3

FIG.4

FIG.5

A. Mozer 10
15. 3. 88